# EUROPÄISCHE PATENTSCHRIFT

(11) **EP 3 836 188 B1**
(45) Veröffentlichungstag und Bekanntmachung des Hinweises auf die Patenterteilung: **09.10.2024**
(21) Anmeldenummer: 21154387.1
(22) Anmeldetag: 27.11.2017
(51) Int. Cl.: H01J 37/317, H01J 37/05, H01L 21/265, H01L 21/04

(54) **VERFAHREN UND VORRICHTUNG ZUR IONENIMPLANTATION IN WAFERN**
METHOD AND DEVICE FOR ION IMPLANTATION IN WAFERS
PROCÉDÉ ET DISPOSITIF D'IMPLANTATION IONIQUE DANS DES PLAQUETTES SEMI-CONDUCTRICES

(30) Priorität: 25.11.2016 DE 102016122791
(43) Veröffentlichungstag der Anmeldung: 16.06.2021
(62) Teilanmeldung aus: 17804894.8
(73) Patentinhaber: mi2-factory GmbH, 07745 Jena (DE)
(72) Erfinder: Krippendorf, Florian, 07743 Jena (DE); Csato, Constantin, 95236 Stammbach (DE)
(74) Vertreter: Wächter, Jochen

(56) Entgegenhaltungen:
- WO-A1-2007/013869
- CN-A- 105 551 922
- JP-A- H05 179 447
- US-A1- 2007 125 957
- KRIPPENDORF ET AL: "Dotierung von SiC mittels Energiefilter fuer Ionenimplantation", 1 January 2015, MIKROSYSTEMTECHNIK 2015; 4 (CONFERENCE INFO: MIKROSYSTEMTECHNIK 2015 - MIKROSYSTEMTECHNIK KONGRESS 2015; 2015; KARLSRUHE, DEUTSCHLAND),, PAGE(S) 334 - 337, XP009194563
- WEIJIANG ZHAO ET AL: "A study on Silicon Carbide (SiC) wafer using ion implantation", 2014 20TH INTERNATIONAL CONFERENCE ON ION IMPLANTATION TECHNOLOGY (IIT), IEEE, 26 June 2014 (2014-06-26), pages 1 - 4, XP032671179, DOI: 10.1109/IIT.2014.6940058

## Beschreibung

Die Erfindung betrifft ein Verfahren und eine Vorrichtung zur lonenimplantation in Wafern.

Konkreter beschäftigt sich die Erfindung mit apparativen Aspekten der Dotierung von Halbleitern bzw. der Erzeugung von Defektprofilen zur Modifikation der Ladungsträgerlebensdauer in Halbleiterbauelementen mittels Einsatz eines Energiefilters für lonenimplantation.

Hierzu existieren beispielsweise folgende Referenzen:
[1] ICSCRM2015: "Alternative highly homogenous drift layer doping for 650 V SiC devices" R. Rupp, W. Schustereder, Tobias Höchbauer, Ronny Kern, Michael Rüb, Constantin Casato, Florian Krippendorf
[2] "Energy filter for tailoring depth profiles in semiconductor doping application" - Constantin Csato, Florian Krippendorf, Shavkat Akhmadaliev, Johannes von Borany, Weiqi Han, Thomas Siefke, Andre Zowalla, Michael Rüb, Nucl. Instr. Meth. B (2015), http://dx.doi.org/10.1016/j.nimb.2015.07.102
[3] "Analysis of lateral energy distribution for passive ion beam scattering element" - Weiqi Han, Constantin Csato, Florian Krippendorf, Michael Rüb, Carsten Ronning, DPG Frühjahrstagung Dresden, März 2014
[4] "Investigation of dopant profiles, losses and heating using an energy filter for ion implantation" - Krippendorf, Csato, Rüb, DPG Frühjahrstagung Dresden, März 2014
   "The Gap Between Research and Commercial Product in Applied Physics Research - An Issue for Sustainability and an Opportunity?" - Prof. Dr. Michael Rueb, University of Applied Sciences Jena, 6th ICEBE International Conference on Engineering and Business Education, Windhoek, Namibia, 7.-10. Oktober 2013
[5] "Energiefilter für Ionenimplantation" - F. Krippendorf, C. Csato, T. Bischof, S. Gupta, W. Han, M. Nobst, Ernst-Abbe-Fachhochschule Jena; C. Ronning, Friedrich-Schiller-Universität Jena; R. Rupp, Infineon Technologies AG, Neubiberg; A. Schewior, Ernst-Abbe-Fachhochschule Jena; W. Wesch, Friedrich-Schiller-Universität Jena; W. Morgenroth, Institut für Photonische Technologien e.V., Jena; M. Rüb, Ernst-Abbe-Fachhochschule Jena, Mikrosystemtechnik Kongress, Aachen, Oktober 2014, "Energiefilter für lonenimplantationsanlagen Idee- erste Experimente - Anwendung, C."
[6] Csato, T. Bischof, S. Gupta, W. Han, F. Krippendorf, W.Morgenroth, M. Nobst, C. Ronning, R. Rupp, A. Schewior, W. Wesch, M. Rüb, 12. Juni 2013, Workshop "lonenstrahlen - Forschung und Anwendung" 2013, Leibniz-Institut für Oberflächenmodifizierung Leipzig, M. Rüb, T. Bischof, C. Csato, S. Gupta, W. Han, F. Krippendorf, A. Schewior, C. Möse, "Energiefilter für lonenimplantationsanlagen", Forschungsbericht der Ernst-Abbe-Fachhochschule Jena 2011/2012
[7] EP 0 014 516 A1
[8] Rüb, "Energiefilter für Hochenergieionenimplantation", IP.com Offenlegungsnummer: IPCOM000018006D , ursprüngliches Veröffentlichungsdatum: 1. Dezember 2001, aufgenommen in der Datenbank zum Stand der Technik: 23. Juli 2003 bzw. Siemens AG, 2001, Siemens Technik Report, Dez. 2001, 9 Seiten.
[9] DE 10 2011 075350 A1

In der mikrotechnischen kommerziell ausgerichteten Produktion werden mittels Ionenimplantation die Dotierung bzw. die Erzeugung von Defektprofilen in beliebigen Materialien, wie etwa Halbleitern (Silizium, Siliziumcarbid, Galliumnitrid) oder optischen Materialien (LiNbO3), mit vordefinierten Tiefenprofilen im Tiefenbereich von wenigen Nanometern bis hin zu einigen 100 Mikrometern realisiert.

Hierzu eignet sich ein sogenanntes Energiefilter 6 für Ionenimplantation. Ein solches Energiefilter 6 ist beispielsweise in EP 0 014 516 A1 beschrieben und in Fig. 1 dargestellt. In Fig. 2 ist ein möglicher Einbau eines Energiefilters 6 in eine Anlage zur lonenimplantation zum Zwecke der Waferprozessierung dargestellt. Bezugszeichen 2 bezeichnet den lonenstrahl, Bezugszeichen 3 bezeichnet ein erstes Ion, Bezugszeichen 4 bezeichnet ein zweites Ion, Bezugszeichen 8 bezeichnet das Substrat, Bezugszeichen 10 bezeichnet eine Rechteckverteilung (mit Filter) und Bezugszeichen 12 bezeichnet eine Gaußverteilung (ohne Filter).

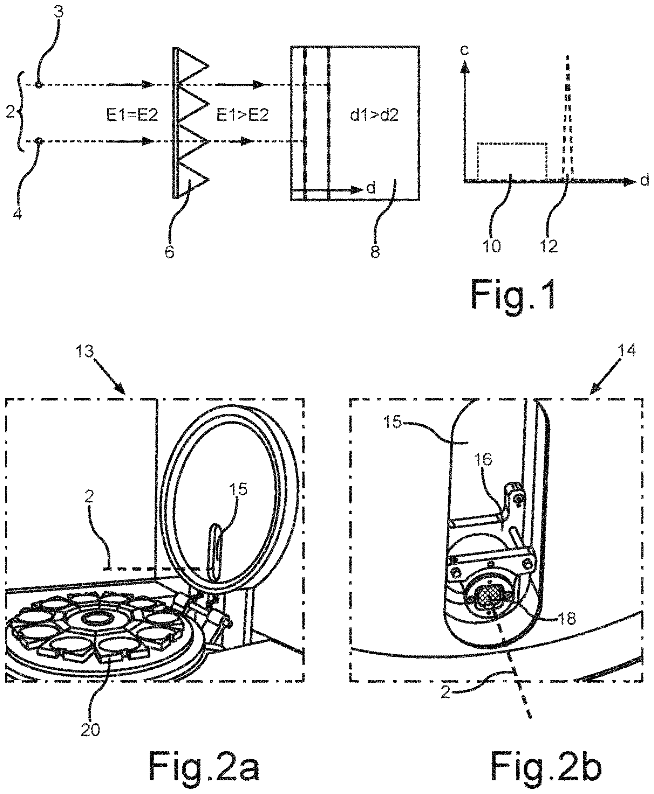

Das Energiefilter 6 ist derart strukturiert, dass es unterschiedlich dicke Bereiche besitzt. Der dickste Bereich ist beispielsweise mehr als 1,5-mal, mehr als 2-mal, mehr als 3-mal oder mehr als 5-mal so dick wie der dünnste Bereich. Die Struktur kann beispielsweise dreieckförmig sein, wie in Fig. 1 dargestellt ist. Dies ist jedoch nur ein Beispiel. Beliebige andere Strukturen sind ebenfalls möglich.

Das Grundprinzip des Energiefilters 6 ist wie folgt: Ein monoenergetischer lonenstrahl 2 wird beim Durchtritt durch die mikrostrukturierte Energiefilterkomponente abhängig vom Eintrittsort in seiner Energie modifiziert. Die resultierende Energieverteilung der Ionen führt zu einer Modifikation des Tiefenprofils des implantierten Stoffes in der Matrix des Substrats 8.

In Fig. 2a und 2b ist die Anordnung von Wafern auf einem rotierenden Waferrad 20 in Kombination mit einem statischen, d.h. vornehmlich Gauß'schen lonenstrahl 2 gezeigt. Bezugszeichen 13 bezeichnet die Implantationskammer, Bezugszeichen 14 bezeichnet den Strahllinien-Einsatz 14, Bezugszeichen 15 bezeichnet die Strahlöffnung und Bezugszeichen 16 bezeichnet die Aufhängung für die Filtermembran 18.

Energiefilteraufhängung 16 und Waferrad 20 sind im Beispiel der Fig. 2a und 2b in einer vakuumtechnischen Einheit, der sogenannten Endstation angeordnet. Fig. 2a zeigt ein Waferrad 20, auf welchem die zu implantierenden Substrate 8 fixiert werden. Bei der Prozessierung/Implantation wird das Waferrad 20 um 90° gekippt und in Rotation versetzt. Das Waferrad 20 wird somit in konzentrischen Kreisen durch den gestrichelt angedeuteten lonenstrahl 2 mit Ionen "beschrieben". Um die gesamte Waferfläche zu bestrahlen, wird das Waferrad 20 während der Prozessierung vertikal bewegt, d.h. das Waferrad 20 pendelt in vertikaler Richtung. Fig. 2b zeigt das montierte Energiefilter 6 im Bereich des Strahlaustritts.

Schließlich wurde gezeigt, dass die Erhöhung der Substrattemperatur, insbesondere bei Verwendung von SiC, zu einer Reduktion der Punktdefektkonzentration führt. Dies ist insbesondere bei Hochdosisimplantationen von Al in SiC beobachtet worden. Siehe hierzu V. Heera et al, Applied Surface Science 184(2001) 307-316; C.A. Fisher et al, 11th European Conference on Silicon Carbide and Related Materials, September 2016, Halkidiki, Greece, Book of Abstracts; N.S. Saks et al, Applied Physics Letters 84, 5195 [2004]; doi 10.1063/1.1764934. Bekannt sind "als implantiert" nur gaußförmige (genauer Pearson-verteilte) Fremdatomprofile, die bei Hochtemperaturimplantation eine ebenfalls gaußförmige, jedoch im Vergleich zu Niedertemperaturimplantationen reduzierte Konzentration (auch Peakkonzentration) an Punktdefekten aufweisen. Außerdem können mittels Hochtempertaturimplantation erzeugte Dotierprofile in nachfolgenden Ausheilprozessen einen höheren Aktivierungsgrad und eine bessere Reproduzierbarkeit des Aktivierungsgrades zeigen.

Die vorliegende Erfindung liefert Lösungen für folgende Problemstellungen:

Es ist wünschenswert, auf die mechanisch aufwändige Rotations- und Pendelbewegung des Waferrades 20 verzichten zu können.

Wird das Energiefilter 6 in einer Öffnung der Implantationskammer 13 (die auch als Bestrahlungskammer oder Waferkammer bezeichnet werden kann) positioniert, wie dies in Fig. 2a und 2b gezeigt ist, kann es bei Erzeugen oder Abbauen eines Vakuums (Abpumpen/Belüften) in der Bestrahlungskammer zu mechanischen Belastungen der Filtermembran 18 durch den Sog der Vakuumpumpen bzw. durch die einströmende Luft kommen. Weiterhin können Partikelablagerungen aus der partikelbelasteten Umgebungsluft in den Mikrostrukturen der mikrostrukturierten Filtermembran 18 die Funktionalität des Energiefilters 6 beeinträchtigen. Solche mechanischen Belastungen und Partikelablagerungen sollten vermieden werden.

Es ist wünschenswert, dass während der Implantation möglichst wenige Punktdefekte im Halbleitermaterial erzeugt werden. Bekannte Defektprofile für eine Kettenimplantation mit mehreren diskreten Implantationsenergien sind in Fig. 3a und 3b gezeigt, vgl. auch DE 102 39 312 B4. In Fig. 3a und 3b steht PDC für Punktdefektkonzentration und d für Tiefe. Bezugszeichen 22 steht für die Welligkeit des Defektprofils und Bezugszeichen 24 steht für die Abnahme wegen Summationseffekten.

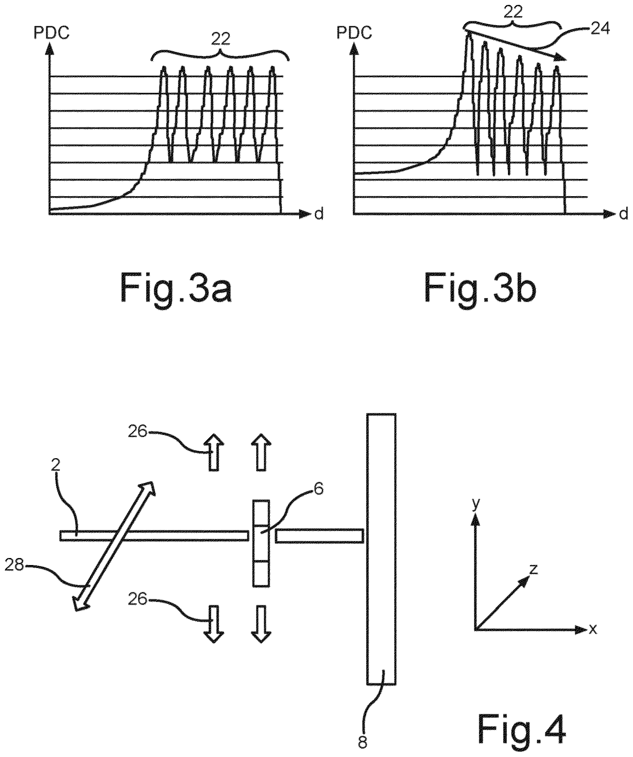

Es sind zwei Fälle unterschieden. Fall 1 (Fig. 3a) ist für den Fall, dass es zu keiner Aufsummation der Punktdefekte durch die tiefergelagerten Implantationen kommt. Solche Effekte der Selbstausheilung durch lonenimplantation sind bekannt, siehe Wendler et al, Nuclear Instruments and Methods in Physics Research B 141 (1998) 105-117; und Rambach et al, Nucl. Instr. and Meth. In Phys. Res. B237 (2005) 68-71. Fall 2 (Fig. 3b) ist der Fall, dass sich die Punktdefektkonzentration aufsummiert.

Bei der Lösung der oben genannten Problemstellungen sollten insbesondere folgende Nebenbedingungen beachtet werden:
(A) Der Abstand zwischen Energiefilter 6 und Substrat 8 (Wafer) bei der Implantation sollte zwischen einigen Millimetern und wenigen Zentimetern betragen.
(B) Das Energiefilter 6 sollte in seinen lateralen Abmessungen möglichst groß sein, um den Energieeintrag durch den lonenstrahl 2 auf eine möglichst große Fläche zu verteilen. Dadurch wird die Aufheizung des Energiefilters 6 verringert und die Stromtragfähigkeit erhöht.
(C) Die Aufnahme des Energiefilters 6 sollte möglichst flexibel zu gestalten sein, da nach heutigem Entwicklungsstand zu erwarten ist, dass für unterschiedliche Applikationen unterschiedliche Konzepte der Energiefilterausgestaltung benötigt werden.
(D) Die Filtermembran 18 sollte möglichst keinen mechanischen Vibrationen ausgesetzt sein, wie sie etwa bei Belüftungs- und Abpumpvorgängen während des Wechsels der zu bestrahlenden Substrate 8 auftreten können.
(E) Die mikrostrukturierte Filtermembran 18 sollte möglichst nicht der partikelbehafteten Außenluft ausgesetzt sein, da bei Ablagerung von Partikeln ggfs. die Funktionalität des Energiefilters 6 eingeschränkt sein könnte.
(F) Die Vorrichtung zur Anordnung des Energiefilters 6 und des Waferchucks 45 oder Waferrads 20 sollte so gestaltet sein, dass durch Anwendung des Energiefilters 6 Implantationsprofile derart erzeugt werden, dass die Generation von Punktdefekten, insbesondere im Fall des Halbleitermaterials SiC, reduziert sein soll.

Eine erfindungsgemäße Lösung ist in dem unabhängigen Anspruch 1 definiert und wird nach-folgend unter Bezugnahme auf die Zeichnungen näher beschrieben. Beschrieben werden insbesondere mögliche Ausgestaltungen einer lonenimplantationsanlage oder von Teilen einer solchen lonenimplantationsanlage und Verfahren zum Betreiben einer lonenimplantationsanlage und von deren Teilen. Diese Anlagen und Verfahren eignen sich für die Implantation von Ionen in Wafer aus einem beliebigen Halbleitermaterial, insbesondere jedoch für Wafer auf Basis von Siliziumkarbid (SiC).
Fig. 1 zeigt das Grundprinzip eines Energiefilters 6 bei der Ionenimplantation;
Fig. 2a ist eine Darstellung einer Implantationskammer 13 nach dem Stand der Technik;
Fig. 2b ist eine Darstellung eines Strahllinien-Einsatzes 14 mit Filtermembran 18 nach dem Stand der Technik;
Fig. 3a und 3b zeigen bekannte Punktdefektkonzentrationsprofile in SiC für diskrete Kettenimplantationen;
Fig. 4 ist eine Querschnittsansicht eines lonenimplantations-Setups mit fixiertem Substrat, gescanntem lonenstrahl sowie implementiertem Energiefilter mit synchronisierter Pendelbewegung zwischen lonenstrahl und Energiefilter in y-Richtung;
Fig. 5 ist eine Darstellung einer angepassten lonenstrahlablenkung zur Bestrahlung der aktiven Fläche des Energiefilters;
Fig. 6 zeigt eine schematische Darstellung der Bestrahlung eines Substrates mit i) (Fig. 6 rechts) konstanter Strahl-Pendelgeschwindigkeit in y und z und konstanter Energiefilter-Pendelbewegung in y bei konstantem lonenstrom und ii) (Fig. 6 links) reduzierter Bestrahlungsfläche durch variable Filter-Pendelbewegung in y und variabler lonenstrahlbewegung in y und z bei konstantem lonenstrom;
Fig. 7 zeigt eine schematische Darstellung der Bestrahlung reduzierter Fläche mit variabler Pendelbewegung des Energiefilters;
Fig. 8 zeigt eine separate Filterkammer, die der eigentlichen Waferkammer vorgelagert ist;
Fig. 9 zeigt eine separate Filterkammer, die der eigentlichen Waferkammer vorgelagert ist, wobei die Vorrichtung zur Halterung des Energiefilters so angeordnet ist, dass sie, bezogen auf den Waferchuck, vorwärts oder rückwärts in die Nähe des Waferchucks gefahren werden kann;
Fig. 10 zeigt eine separate Filterkammer, die innerhalb der Waferkammer angeordnet ist;
Fig. 11 zeigt eine Energiefilteranordnung in Kombination mit einer heizbaren Waferaufnahmeeinrichtung;
Fig. 12 zeigt ein neuartiges Defekt- und Fremdatomprofil (Fall 1);
Fig. 13 zeigt ein neuartiges Defekt- und Fremdatomprofil (Fall 2); und
Fig. 14 zeigt ein neuartiges Defekt- und Fremdatomprofil, genauer ein von der Oberfläche isoliertes Dotierprofil.

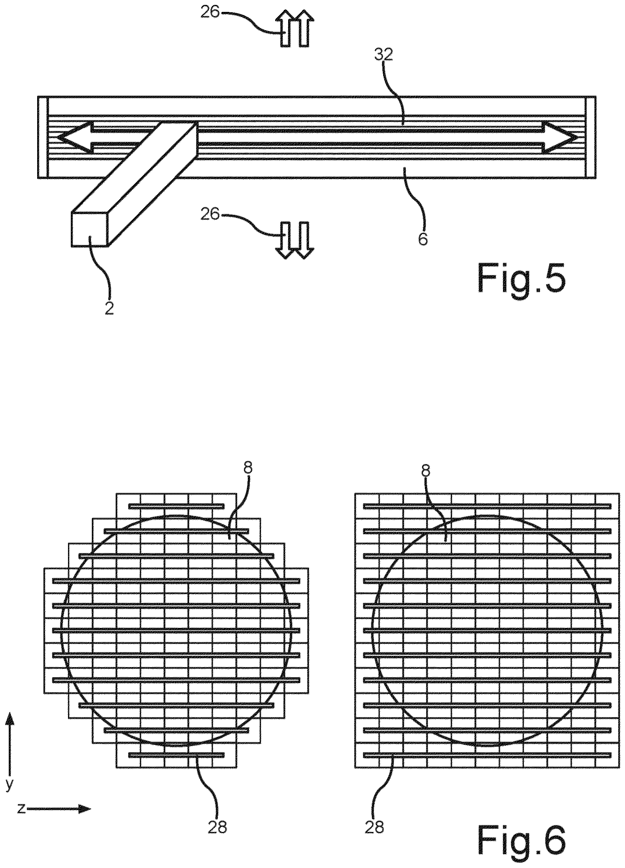

Im Folgenden wird eine Möglichkeit zur lonenimplantation unter Verwendung eines Implantationsfilters näher beschrieben. Für eine homogene Bestrahlung eines Wafers 8 (Substrat) sollte der durch das Implantationsfilter 6 geleitete lonenstrahl 2 während der Implantation die gesamte Waferfläche (Substratfläche) überstreichen (scannen). Hierzu ist eine elektrostatische Ablenkung (Scanning) des lonenstrahls 2 in Kombination mit einer mechanischen Bewegung des Filters 6 vorgesehen. Ein möglicher Aufbau ist in den Fig. 4 und 5 gezeigt. Bezugszeichen 2 bezeichnet den lonenstrahl, Bezugszeichen 6 bezeichnet das Filter 6, Bezugszeichen 8 bezeichnet das Substrat/den Wafer, Bezugszeichen 26 bezeichnet die synchronisierte Pendelbewegung zwischen Filter und lonenstrahl in y-Richtung und Bezugszeichen 28 bezeichnet die Pendelbewegung des lonenstrahls in z-Richtung.

Das Scanning erfolgt in y- und z-Richtung elektrostatisch, jedoch für jede Richtung auf unterschiedliche Art und Weise. In z-Richtung erfolgt ein schnelles Scanning, sodass das schlitzartige Energiefilter 6 über die gesamte aktive Fläche bestrahlt wird. Das Scanning in y-Richtung geschieht durch eine langsame elektrostatische Pendelbewegung, welche synchron mit einer gekoppelten mechanischen Pendelbewegung des Filters 6 ausgeführt wird. Somit weisen der lonenstrahl 2 und die aktive Fläche des Energiefilters 6 stets Deckungsgleichheit auf, so dass der lonenstrahl 2 stets durch das Filter 6 geleitet wird, bevor er auf den Wafer 8 trifft. In der z-Richtung kann eine Abmessung des Filters 6 der maximalen Abmessung des Wafers 8 in der z-Richtung entsprechen, so dass in der z-Richtung keine mechanische Bewegung des Filters 6 erforderlich ist und nur der lonenstrahl 2 in dieser z-Richtung bewegt wird. In der y-Richtung ist die Abmessung des Filters 6 kleiner als die maximale Abmessung des Wafers 8, so dass in dieser Richtung das Filter 6 synchron mit dem lonenstrahl 2 bewegt wird, um während der Implantation sukzessive alle Bereiche des Wafers 8 mit dem durch das Filter 6 geleiteten lonenstrahl 2 zu bestrahlen.

Eine weitere Abwandlung der oben beschriebenen Ausführungsform ist im Folgenden dargelegt:
Für eine Durchsatzoptimierung des Energiefilters 6 kann es wünschenswert sein, die bestrahlte Fläche neben dem Wafer 8 (Overscan) möglichst klein zu halten, d.h. möglichst nur den runden Wafer 8, nicht jedoch den Wafer 8 umgebende Bereiche zu bestrahlen. Im einfachsten Fall der Bestrahlung nach Fig. 4, Fig. 5 und Fig. 6 rechts ist die Pendelbewegung des lonenstrahls 2 stets gleich, d.h. der lonenstrahl 2 bewegt sich in der z-Richtung stets zwischen zwei gleichen Endpunkten (z0 und z1) und in der y-Richtung stets zwischen zwei gleichen Endpunkten (y0 und y1). Das Filter 6 bewegt sich in der y-Richtung synchron mit dem lonenstrahl 2 zwischen den jeweiligen Endpunkten. Dies führt zu einer rechteckförmigen Bestrahlungsfläche, d.h. der von dem lonenstrahl 2 überstrichene Bereich ist rechteckig und die Koordinaten seiner Eckpunkte sind durch die Endpunkte der Pendelbewegung des lonenstrahls 2 in y-Richtung und z-Richtung gegeben. Diese Koordinaten sind beispielsweise (z0, y0), (z1, y0), (z0, y1), (z1, y1).

Bei einem runden Wafer 8 werden dadurch auch Flächen bestrahlt, die innerhalb des rechteckigen Bestrahlungsbereichs, aber außerhalb des Wafers 8 liegen. Dies ist anhand von Fig. 6 rechts gezeigt, wo die Pendelbewegung des lonenstrahls 2 innerhalb eines rechteckigen Bestrahlungsbereichs und ein runder Wafer 8 veranschaulicht sind.

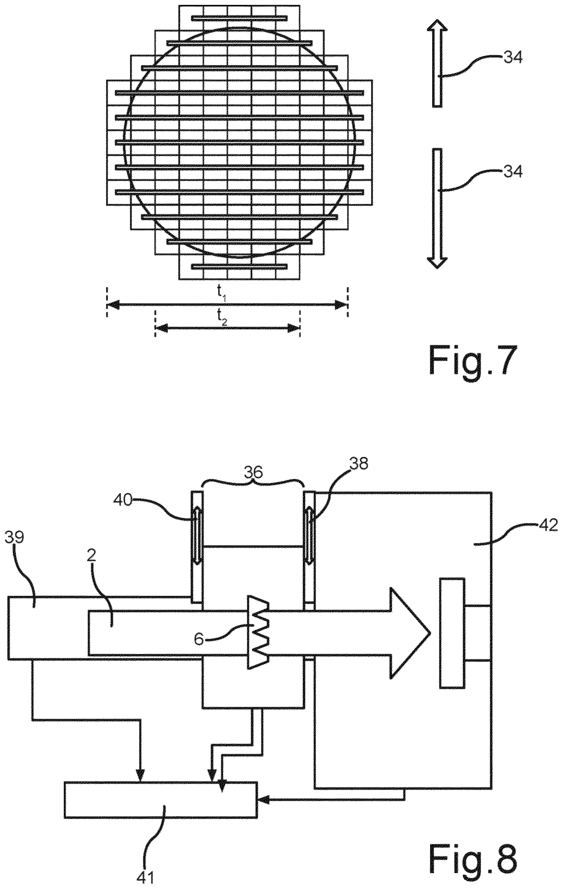

Eine Substrat-optimierte Ablenkung des lonenstrahls 2 in z-Richtung ist in Fig. 6 links und Fig. 7 dargestellt. Fig. 7 zeigt die Bestrahlung reduzierter Fläche mit variabler Filter-Pendelgeschwindigkeit und Strahlgeschwindigkeit. t₁ und t₂ repräsentieren unterschiedliche Bestrahlungszeiten der Strahllinien. Bezugszeichen 34 bezeichnet die variable Pendelbewegung der Filtereinheit 6 und des lonenstrahls 2.

Gemäß Fig. 6 links und Fig. 7 wird der lonenstrahl 2 in z-Richtung nur so weit abgelenkt, dass der lonenstrahl 2 im Wesentlichen nur den Wafer 8 trifft. Die Endpunkte der Ablenkung des lonenstrahls 2 in z-Richtung sind hierbei an die Abmessungen des Wafers 8 angepasst. Gemäß einem Beispiel ist vorgesehen, den lonenstrahl 2 in der z-Richtung mit im Wesentlichen konstanter Geschwindigkeit zu bewegen, um überall dort, wo bestrahlt wird, eine annähernd gleiche Implantationsdosis zu erhalten. Wie lange es hierbei dauert, den Wafer 8 in der z-Richtung einmal oder definiert mehrmals mit dem lonenstrahl 2 zu überstreichen, ist von der Breite des Wafers 8 an der jeweiligen y-Position abhängig. Diese Dauer kann als Verweildauer des Filters 6 an der jeweiligen y-Position bezeichnet werden, wobei sich diese Verweildauer von y-Position zu y-Position ändern kann, wenn sich das Filter 6 synchron zu dem lonenstrahl 2 in der y-Richtung bewegt.

Gemäß einem Beispiel ist vorgesehen, dass sich das Filter 6 in der y-Richtung schrittweise bewegt. Gemäß einem weiteren Beispiel ist vorgesehen, dass sich das Filter 6 in der y-Richtung kontinuierlich bewegt. In diesem Fall wird die Geschwindigkeit der langsamen Pendelbewegung des lonenstrahles 2 und des Energiefilters 6 in der y-Richtung an die Zeit angepasst, die der lonenstrahl 2 benötigt, um den Wafer in der z-Richtung einmal oder mehrmals zu überstreichen, um stets Deckungsgleichheit des lonenstrahls 2 und des Energiefilters 6 zu gewährleisten, d.h. um zu gewährleisten, dass der lonenstrahl 2 stets durch das Filter 6 auf den Wafer trifft.

Im Folgenden werden Ausführungsformen der Erfindung beschrieben

Der wesentliche Gedanke besteht dabei darin, die Vorrichtungen, die für den Einbau des Energiefilterchips in die Bestrahlungsanlage benötigt werden, in einer zur Waferkammer 42 (die auch als Waferendstation, Waferhandlingskammer oder Implantationskammer bezeichnet werden kann) separaten, vakuumtechnisch abschließbaren Einheit (die auch als Filterkammer 36 bezeichnet werden kann) anzuordnen, wie dies beispielsweise in Fig. 8 dargestellt ist.

Die Filterkammer 36 weist zwei Öffnungen auf, die durch Verschlüsse bzw. Ventile (erstes Vakuumventil 38 und zweites Vakuumventil 40 in Fig. 8) verschlossen werden können. Diese Verschlüsse werden im Bestrahlungsbetrieb geöffnet und sind so angeordnet, dass der lonenstrahl 2 bei geöffneten Verschlüssen vom Beschleuniger kommend ungehindert durch den Filter 6 auf das zu bestrahlende Substrat 8 treten kann. Sind die Öffnungen geschlossen, so ist das Filter 6 in der Filterkammer 36 vor mechanischen äußeren Einflüssen geschützt. Gemäß einem Beispiel sind die Öffnungen durch die Verschlüsse druckdicht verschließbar, so dass nach dem Schlie-ßen dieselben Druckverhältnisse erhalten bleiben, die vor dem Schließen in der Filterkammer 36 geherrscht haben. An die Filterkammer 36 kann eine Vakuumpumpe 41 angeschlossen sein, die bei geschlossenen Öffnungen Druckschwankungen ausgleichen kann, die sich beispielsweise durch nicht hermetisch dichte Verschlüsse ergeben können.

Wenn die Waferkammer 42 z.B. zum Substratwechsel belüftet werden muss, werden vor der Belüftung die Öffnungen geschlossen. Die separate Filterkammer 36 wird weiterhin bepumpt, so dass die Partikelbelastung des Filters 6 minimiert wird und die Druckverhältnisse konstant bleiben. Mechanische Belastung des Filters 6 durch Abpump- oder Belüftungsvorgänge werden auf diese Weise vermieden.

Die separate Energiefilter-Vakuumkammer 36 ist geschlossen während der Waferzuführung und offen während der Implantation. Sie ist getrennt von der Waferkammer 42 mittels wenigstens eines Vakuumventils 38. Die Waferkammer 42 ist als "kommerzielle" Waferkammer 42 nach dem Stand der Technik ausgebildet. Während der lonenimplantation liegen in ihr Hochvakuum- oder Ultrahochvakuumbedingungen vor. Der Filter 6 ist befestigt gemäß dem Stand der Technik und/oder gemäß flexiblen Halterungsoptionen. Es können ein gemeinsames oder mehrere unabhängige Vakuumpumpsysteme 41 vorliegen.

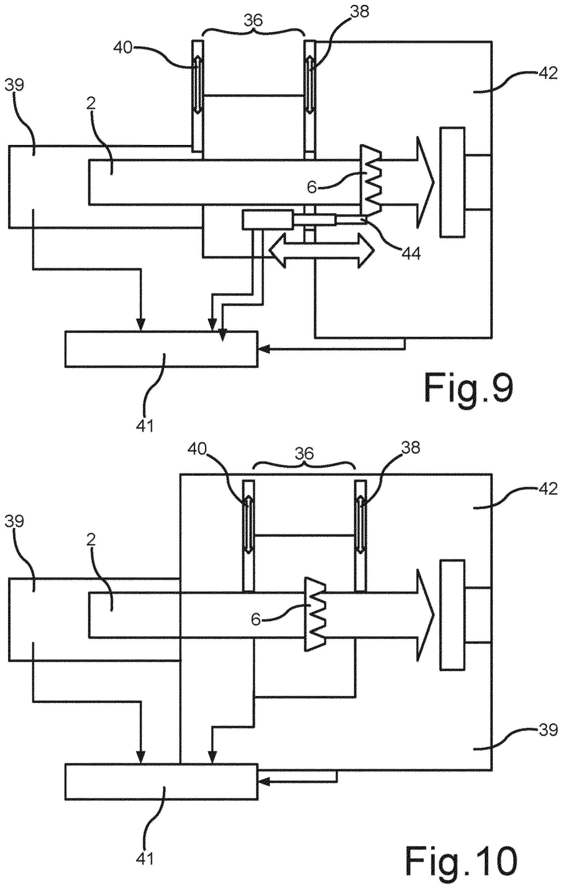

In einer weiteren Ausführungsform, siehe Fig. 9, wird das Energiefilter 6 in der vorgelagerten separaten Vakuumeinheit (Filterkammer 36) auf einer beweglichen Vorrichtung (Filterhalterung 44) angeordnet. Diese Vorrichtung 44 dient dazu, das Energiefilter 6, das möglicherweise bedingt durch die Bauart der separaten Vakuumeinheit 36 und des Waferchucks 45 zwischen Substrat 8 und Filter 6 einen zu großen Abstand aufweist, näher an das zu bestrahlende Substrat 8 heranzubringen. Dabei kann (muss aber nicht) das Filter 6 auch durch einen der geöffneten Verschlüsse bzw. Vakuumventile (Vakuumventil 38 in Fig. 9) hindurchbewegt werden. Vor Schließen der Filterkammer 36, beispielsweise bei einem Waferwechsel, wird das Filter 6 dann wieder in die Filterkammer 36 zurückbewegt. Die Energiefilterhalterung 44 wird mechanisch zur Waferendstation 42 transferiert, um den Abstand zwischen Wafer 8 und Filter 6 einzustellen. Der Doppelpfeil deutet die vorwärts/rückwärts bewegbare Energiefilterinstallation an. Ansonsten bezeichnen die Bezugszeichen dieselben Elemente mit denselben Eigenschaften wie in Fig. 8. Bei den in Fig. 8 und 9 gezeigten Beispielen ist die Filterkammer 36 außerhalb der Waferkammer 42 vor der Strahlöffnung (Implantationsöffnung) der Waferkammer 42 angeordnet. Die Strahlöffnung ist die Öffnung, durch die der lonenstrahl 2 in die Waferkammer 42 eintritt. Bei einer weiteren Ausführungsform, siehe Fig. 10, ist die oben beschriebene separate vakuumtechnische Einheit (Filterkammer 36) zur Aufnahme des Energiefilterchips innerhalb der Waferkammer 42 (Endstation) angeordnet. Auch in diesem Fall kann das mechanische Verfahren des Filters 6 in Richtung Substrat 8 notwendig sein. Ansonsten bezeichnen die Bezugszeichen dieselben Elemente mit denselben Eigenschaften wie in Fig. 8.

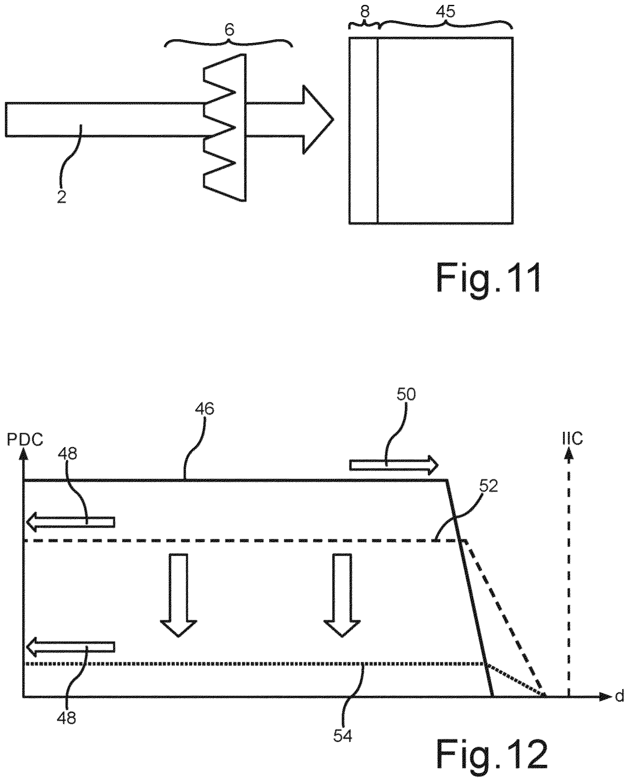

Weitere Möglichkeiten der lonenimplantation unter Verwendung eines Energiefilters werden im Folgenden unter Bezugnahme auf Fig. 11 bis 14 beschrieben. Dabei bezeichnen die Achsenbeschriftungen PDC die Punktdefektkonzentration, IIC die implantierte lonenkonzentration und d die Tiefe. Bezugszeichen 46 bezeichnet die implantierte lonenkonzentration, Bezugszeichen 48 bezeichnet die linke Achse, Bezugszeichen 50 bezeichnet die rechte Achse, Bezugszeichen 52 bezeichnet die Kaltimplantations-Defektkonzentration, Bezugszeichen 54 bezeichnet die Heißimplantations-Defektkonzentration, Bezugszeichen 56 bezeichnet Nicht-End-of-Range-Defekte, Bezugszeichen 58 bezeichnet End-of-Range-Defekte 58 und die beiden nach unten gerichteten parallelen Pfeile in Fig. 12 bis 14 deuten die reduzierte Defektkonzentration an.

Während jeder lonenimplantation kommt es aufgrund von Kollisionen der eingeschossenen Ionen mit Atomen des Substratmaterials zur Bildung von Punktdefekten. Diese Punktdefekte erreichen bei ungefilterten Implantationen im End-of-Range-Bereich der eingeschossenen Fremdatome ein Konzentrationsmaximum.

Vorgeschlagen wird der Einsatz eines Energiefilters 6 in Kombination mit einem beheizbaren Waferchuck 45, siehe Fig. 11. Der "Waferchuck" 45 ist eine Aufnahme für den Wafer 8 in der Waferkammer 42 und hält den Wafer 8 während der Implantation. Mit der in Fig. 11 skizzierten neuartigen Anordnung einer heizbaren Waferaufnahme (Waferchuck 45, Waferrad 20 oder einer beliebigen anderen Aufnahme) und einem Energiefilter 6 für Ionenimplantation lassen sich bisher nicht bekannte Kombinationen von Punktdefekt- und Fremdatomprofilen erzeugen. Eine beheizbare Waferaufnahme 45 eignet sich für Wafer 8 aus SiC, jedoch auch für Wafer 8 aus beliebigen anderen Halbleitermaterialien.

Das Energiefilter 6 kann dabei im Prinzip in jeder Art von Anordnung vorliegen, wie z.B. statisch, bewegbar, in separater Kammer, in derselben Kammerwie der Waferchuck 45, kleiner als der Wafer 8, größer als oder gleich groß wie der Wafer 8, rotierend, mit Kollimationsstruktur etc. Erfindungsgemäß ist die Anrodnung in einer separaten Kammer wie in Anspruch 1 beschrieben vorgesehen.

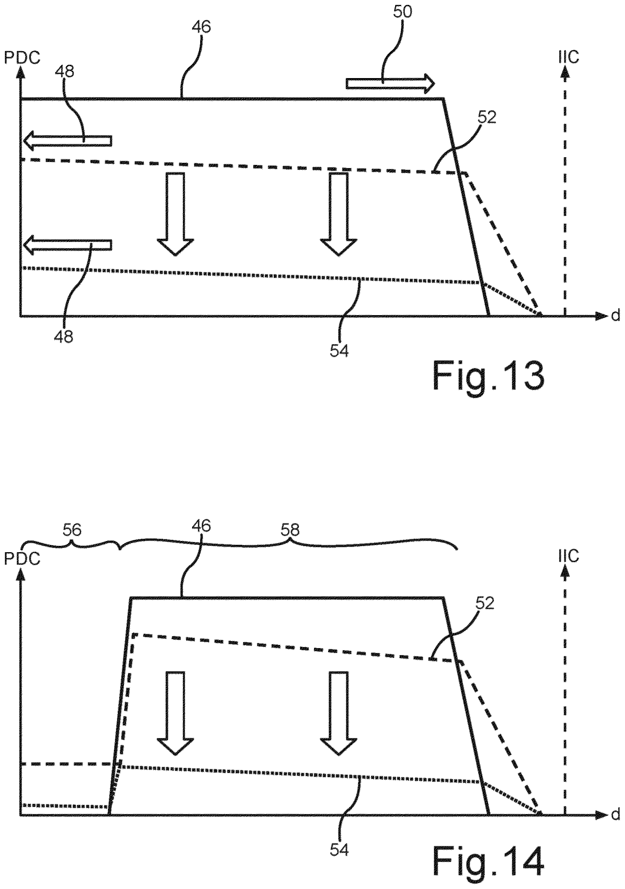

Profilkombinationen, die sich durch Bestrahlen eines Wafers 8 über ein Energiefilter 6 erreichen lassen, haben beispielsweise folgende Eigenschaften:
- Die Punktdefektkonzentration (PDC) ist im gesamten durch das Energiefilter 6 aufgeweiteten Tiefenbereich der Implantation reduziert.
- Der aufgeweitete Tiefenbereich reicht typischerweise von der Oberfläche bis zu einigen Mikrometern Tiefe, siehe Fig. 12 und 13.
- Die Konzentrationstiefenfunktion der implantierten Fremdatome ist abhängig von der geometrischen und materialtechnischen Ausgestaltung des Energiefilters 6 und somit vollständig beinflussbar. Die Defekttiefenprofile folgen der Form der Konzentrationstiefenfunktion der implantierten Fremdatome und sind für ein gegebenes Substratmaterial durch sie bestimmt, siehe Fig. 12 und 13.
- Die Defektkonzentrationstiefenprofile sind auch davon abhängig, ob es durch den lonenbeschuss in tieferliegenden Gebieten zu ionenstrahlinduzierten Ausheileffekten ("Fall 1") kommt. Somit sind die Fälle "Fall 1" (Fig. 12) und "Fall 2" (Fig. 13 und 14) zu unterscheiden. "Fall 1" umfasst ausdrücklich auch den Fall, dass die ionenstrahlinduzierte Ausheilung sehr effizient ist und es somit (bei boxförmigem Fremdatomprofil) zu einem Anstieg der Defektkonzentration mit der Tiefe kommt.
- Die Fremdatom- und Punktdefekttiefenprofile sind glatt, d.h. sie sind nicht durch peakartige Konzentrationsmaxima und -minima entlang der Tiefe charakterisiert. Es resultiert keine "Welligkeit" des Defektprofils.
- Der aufgeweitete Tiefenbereich kann auch unterhalb der Oberfläche beginnen und sich z.B. beginnend ab 2µm Tiefe bis in eine Tiefe von 6µm erstrecken, siehe Fig. 14. In diesem Fall ist zu unterscheiden zwischen End-of-Range-Defekten 58 und Nicht-End-of-Range-Defekten 56. Für beide Defektarten gilt, dass eine Reduktion der Konzentration durch die erhöhte Temperatur bei der Implantation erreicht wird.
- In einer weiteren Ausführungsform liegt der Tiefenbereich bei < 1µm.
- Das implantierte Ion ist beispielsweise Aluminium mit hohen Konzentrationen.
- Erhöhter Aktivierungsgrad und reproduzierbare Aktivierung im Vergleich zur Niedertemperatur-Energiefilterimplantation
- Die Temperatur des Waferchucks 45 ist ab Raumtemperatur nach oben einstellbar und liegt bevorzugt zwischen T=400°C und T=1.000°C.

Die Beanspruchung der neuartigen Defektprofile (bei erhöhter Implantationstemperatur) erstreckt sich auf alle durch Energiefilteranwendung darstellbaren Implantationsprofile und deren dazugehörigen Defektprofile und für alle Fälle von Defektakkumulation oder ionenstrahlinduziertes Ausheilen, d.h. insbesondere für die beiden Fälle "Fall 1" und "Fall 2".

Der Wafer 8 ist vorzugsweise ein Halbleiterwafer. Es können aber auch andere Wafer, beispielsweise aus optischen Materialien wie LiNbO3, bearbeitet werden.

Als Waferaufnahme wurden im Rahmen der Beschreibung beispielhaft Waferchuck 45 und Waferrad 20 genannt. Es können aber auch alle anderen herkömmlichen Waferaufnahmen verwendet werden.

### Bezugszeichenliste

- 2: lonenstrahl
- 3: erstes Ion
- 4: zweites Ion
- 6: Implantationsfilter
- 8: Wafer
- 10: Rechteck (mit Filter)
- 12: Gaußverteilung (ohne Filter)
- 13: Implantationskammer
- 14: Strahllinien-Einsatz
- 15: Strahlöffnung
- 16: Aufhängung
- 18: Filtermembran
- 20: Waferrad
- 22: Welligkeit des Defektprofils
- 24: Abnahme wegen Summationseffekten
- 26: synchronisierte Pendelbewegung zwischen Energiefilter und lonenstrahl in y-Richtung
- 28: Pendelbewegung des lonenstrahls in z-Richtung
- 32: aktive Fläche des Energiefilters
- 34: variable Pendelbewegung der Filtereinheit und des lonenstrahls
- 36: Filterkammer
- 38: erstes Vakuumventil
- 39: Vakuumzustand
- 40: zweites Vakuumventil
- 41: Vakuumpumpsystem
- 42: Waferkammer
- 44: Filterhalterung
- 45: Waferchuck
- 46: implantierte lonenkonzentration
- 48: linke Achse
- 50: rechte Achse
- 52: Kaltimplantations-Defektkonzentration
- 54: Heißimplantations-Defektkonzentration
- 56: Nicht-End-of-Range-Defekte
- 58: End-of-Range-Defekte

## Patentansprüche

1. Vorrichtung zur lonenimplantation in Wafern, die aufweist:
eine Waferkammer (42), die eine Waferaufnahme (20, 45) aufweist, die dazu ausgebildet ist, wenigstens einen Wafer (8) aufzunehmen; und
eine zur Waferkammer (42) separate, vakuumtechnisch abschließbare Filterkammer (36), die eine Filterhalterung (44) für einen Energiefilterchip, wobei der Energiefilterchip (6) derart strukturiert ist, dass er unterschiedlich dicke Bereiche besitzt, aufweist und eine erste und zweite, jeweils mittels eines Verschlusses (38, 40) verschließbare Öffnung aufweist, wobei die Verschlüsse (38, 40) derart angeordnet sind, dass bei geöffneten Verschlüssen ein von einem Beschleuniger kommender lonenstrahl ungehindert durch den Energiefilter (6) auf den Wafer (8) treffen kann.

2. Vorrichtung nach Anspruch 1, bei der die Filterhalterung (44) in wenigstens einer Richtung bewegt werden kann, wobei die Filterhalterung (44) über eine von der ersten und zweiten Öffnung aus der Filterkammer (36) hinaus bewegt werden kann.

3. Vorrichtung nach Anspruch 1 oder 2, bei der die Filterkammer (36) in der Waferkammer (42) angeordnet ist.

4. Vorrichtung nach Anspruch 1 oder 2, bei der die Filterkammer (36) außerhalb der Waferkammer (42) angeordnet ist.

5. Vorrichtung nach Anspruch 3 oder 4, bei der die Waferkammer (42) eine Implantationsöffnung aufweist, wobei die Filterhalterung (44), die Implantationsöffnung und die Waferaufnahme (20, 45) derart auf einer Linie liegen, dass ein lonenstrahl (2) durch den in die Filterhalterung (44) eingesetzten Implantationsfilter (6) und die Implantationsöffnung auf den durch die Waferaufnahme (20, 45) gehaltenen Wafer (8) treffen kann.

## Claims

1. A device for ion implantation into wafers, comprising:
a wafer chamber (42), which comprises a wafer holder (20, 45) configured to hold at least one wafer (8), and
a filter chamber (36) separate from the wafer chamber (42), wherein the filter chamber (36) is sealable in a pressure-tight manner and comprises a filter holder (44) for an energy filter chip, wherein the energy filter chip (6) is structured to have areas of different thickness, the filter chamber (44) comprising a first and a second opening closable by respective closures (38, 40), wherein the closures (38, 40) are arranged in such a way that, if the closures are open, an ion beam originating from an accelerator and passing through the energy filter (6) can strike the wafer (8) in an unhindered manner.

2. The device according to claim 1, wherein the filter holder (44) is movable in at least one direction, wherein the filter holder (44) is movable out of the filter chamber (36) beyond one of the first and second openings.

3. The device according to claim 1 or 2, wherein the filter chamber (36) is arranged in the wafer chamber (42).

4. The device according to claim 1 or 2, wherein the filter chamber (36) is arranged outside the wafer chamber (42).

5. The device according to claim 3 or 4, wherein the wafer chamber (42) comprises an implantation opening, wherein the filter holder (44), the implantation opening, and the wafer holder (20, 45) lie on a straight line in such a way that an ion beam (2) passing through the implantation filter (6) inserted in the filter holder (44) and through the implantation opening can strike the wafer (8) held by the wafer holder (20, 45).

## Revendications

1. Dispositif d'implantation ionique dans des plaquettes, ledit dispositif comportant :
une chambre de plaquette (42) qui comporte un logement de plaquette (20, 45) qui est conçu pour recevoir au moins une plaquette (8) ; et
une chambre de filtre (36) séparée de la chambre de plaquette (42) et pouvant être isolée par une technique de vide et comportant un porte-filtre (44) destiné à une puce de filtre d'énergie, la puce de filtre d'énergie (6) étant structurée de manière à présenter des zones d'épaisseurs différentes et présenter une première et une deuxième ouverture qui peuvent chacune être fermée au moyen d'une fermeture (38, 40), les fermetures (38, 40) étant disposées de telle sorte que, lorsque les fermetures sont ouvertes, un faisceau d'ions provenant d'un accélérateur puisse frapper la plaquette (8) sans être gêné par le filtre d'énergie (6).

2. Dispositif selon la revendication 1, dans lequel le porte-filtre (44) est mobile dans au moins une direction, le porte-filtre (44) étant mobile au-delà de l'une des première et deuxième ouvertures de la chambre de filtre (36) .

3. Dispositif selon la revendication 1 ou 2, dans lequel la chambre de filtre (36) est disposée dans la chambre de plaquette (42).

4. Dispositif selon la revendication 1 ou 2, dans lequel la chambre de filtre (36) est disposée à l'extérieur de la chambre de plaquette (42).

5. Dispositif selon la revendication 3 ou 4, dans lequel la chambre de plaquette (42) comporte une ouverture d'implantation, le porte-filtre (44), l'ouverture d'implantation et le logement de plaquette (20, 45) étant situés sur une ligne de manière à ce qu'un faisceau d'ions (2) traverse le filtre d'implantation (6) inséré dans le porte-filtre (44) et l'ouverture d'implantation pour venir frapper la plaquette (8) maintenue par le logement de plaquette (20, 45).
